# EUROPÄISCHE PATENTANMELDUNG

(11) **EP 1 107 310 A2**
(43) Veröffentlichungstag der Anmeldung: **13.06.2001**
(21) Anmeldenummer: 00125739.3
(22) Anmeldetag: 24.11.2000
(51) Int. Cl.: H01L 23/36, H01L 23/13

(54) **Isolationsverbesserung bei Hochleistungs-Halbleitermodulen**

(30) Priorität: 08.12.1999 DE 19959248
(71) Anmelder: DaimlerChrysler Rail Systems GmbH, 13627 Berlin (DE)
(72) Erfinder: Jörg, Pieder, 7013 Domat/Ems (CH); Rhyner, Jakob, 8006 Zürich (CH); Knapp, Wolfgang, 5430 Wettingen (CH); Berth, Matthias, 5400 Baden (CH); Marquardt, Jörg, 5415 Nussbaumen (CH)
(74) Vertreter: Gmeiner, Christa, c/o DaimlerChrysler AG

(57) **Zusammenfassung**

Die vorliegende Erfindung offenbart ein Halbleitermodul mit verbesserter Teilentladungsfestigkeit. Das Halbleitermodul umfasst eine Grundschicht (2), eine erste Metallisierung (3), eine zweite Metallisierung (5) sowie mindestens ein Halbleiterelement (6), die übereinander angeordnet sind. Erfindungsgemäss ist in der Grundschicht (2) und/oder der Isolationsschicht (3) in einem Bereich unter einer Kante der sich in einer Ebene darüber befindlichen ersten bzw. zweiten Metallisierung (4, 5) eine Aussparung (10) derart ausgebildet ist, dass die Kante keine Verbindung mit der sich in der Ebene darunter befindlichen Grundschicht (2) und/oder Isolationsschicht (3) hat. Das gesamte Halbleitermodul ist in eine Gelmasse (7) eingegossen. Auf diese Weise wird ein durch die jeweilige Metallisierungskante nur von der Gelmasse (7) umgeben, so dass Teilentladungen beträchtlich reduziert werden.

## Beschreibung

### Technisches Gebiet

Die Erfindung bezieht sich auf das Gebiet der Halbleiter-Leistungselektronik. Insbesondere bezieht sie sich auf Halbleitermodule und Hochleistungs-Halbleitermodule.

### Stand der Technik

Aus dem Stand der Technik sind integrierte Hochleistungs-Halbleitermodule (Integrierte Power-Module bzw. IPM) bekannt, die mit Spannungen von bis zu 6,5 kV betrieben werden. Angewandt werden derartige Module, an die besonders strenge Anforderungen an die Isolations- und Teilentladungsfestigkeit gestellt werden, um eine geforderte Lebensdauer von ungefähr 30 Jahren gewährleisten zu können, beispielsweise bei Gleichspannungsbahnen.

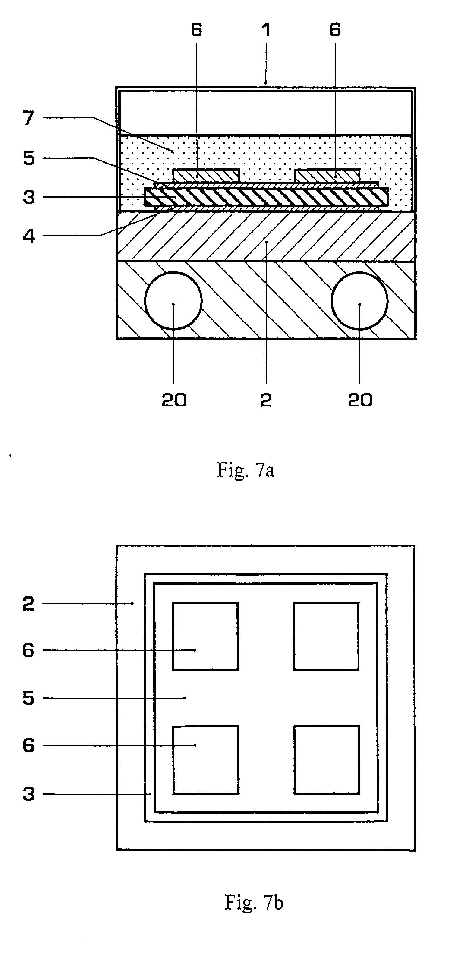

Ein derartiges herkömmliches Hochleistungs-Halbleitermodul ist beispielsweise aus R.Zehringer et al., Materials Research Society Symposium Proceedings, Volume 483, Power Semiconductor Materials and Devices, 1998, S. 369-380 bekannt. Dort ist ein in den Figuren 7a und 7b gezeigtes Halbleitermodul offenbart, das ein Modulgehäuse 1, eine metallene Grundschicht 2 sowie mehrere darauf angeordnete, vom Modulgehäuse überdeckte Halbleiterelemente 6, wie beispielsweise IBGT- bzw. Bipolartransistor mit integrierter Gateelektrode bzw. Integrated Gate Bipolar Transistor-Bausteine und Dioden aufweist. Das Modulgehäuse 1 ist mit einer Gelmasse 7, beispielsweise aus Silikongel ausgefüllt, die als elektrische Isolationsschicht und als Korrosionsschutz dient sowie auf Verbindungsdrähte wirkende Zugkräfte vermindert.

Die Grundschicht 2 ist mit einer Wasserkühlung 20 verbunden, um die von den Halbleiterelementen 6 erzeugte Wärme abzuführen. Auf der Grundschicht 2 ist ein Substrat in der Form eines beidseitig metallisierten Isolationsschicht, beispielsweise einer beidseitig metallisierten Keramikplatte 3 angeordnet.

Diese Isolationsschicht 3 besteht beispielsweise aus Aluminiumnitrid (AIN), bildet eine elektrische Isolation zwischen den Halbleiterelementen 6 und der Grundschicht 2 bzw. Wasserkühlung 20 und weist zudem eine gute Wärmeleitfähigkeit auf, um die Wärme der Halbleiterelemente 6 zur Grundschicht 2 abzuführen. Die Grundschicht 2, die Isolationsschicht 3 und die Halbleiterelemente 6 sind aufeinander gelötet, wobei erste und zweite Metallisierungen 4 und 5 der Isolationsschicht 3 die Lötverbindung ermöglichen. Die Verbindung der zweiten Metallisierung 5 zur Kontaktierung und Zuführung des Kollektorstroms und des Halbleiterelements 6 sowie der ersten Metallisierung 4 zur Verbindung der Isolationsschicht 3 und der Grundschicht 2 sowie der ersten und zweiten Metallisierungen 4 bzw. 5 und der Isoalationsschicht 3 erfolgt über in den Figuren nicht gezeigte Weichlotschichten.

Je nach Modulaufbau sind rein konstruktiv die Anforderungen an die Isolation einschliesslich der Gelmasse 7 bezüglich der elektrischen Felder mehr oder weniger hoch.

In den hier betrachteten Hochleistungs-Halbleitermodulen sind die Anforderungen besonders hoch, da mit dem gewählten flachen Aufbau die Induktivität des Moduls klein gehalten werden kann. Der Feldaufbau ist daher jedoch sehr gedrängt, so dass viele lokale Feldüberhöhungen entstehen.

Hierbei ist die kritische Stelle für die Isolationsfestigkeit vor allem der Isolationsschicht 3, beispielsweise aus Aluminiumnitrid-Keramik, da Durchschläge und Pfade für Teilentladungen vom Halbleiterelement 6 über den Rand der Isolationsschicht 3 zur Grundschicht 2, die auf Massepotential liegt, entstehen. Die Teilentladung tritt dabei an einer Kante 5a der zweiten Metallisierung 5, die das Halbleiterelement 6 trägt, und/oder an einer Kante 4a der ersten Metallisierung 4, die die Isolationsschicht 3 trägt, auf, d.h. an jeweils einem durch die erste bzw. zweite Metallisierung 4 bzw. 5, die Gelmasse 7 und die Isolationsschicht 3 gebildeten Tripelpunkt T bzw. T*. In den meisten Fällen wird hierbei die Teilentladung von Ablösungen zwischen der Gelmasse 7 und der Isolationsschicht 3 verursacht oder begleitet.

Zur Umgehung dieses Problems werden daher derzeit zur Erhöhung der Isolierfestigkeit von Halbleitermodulen teuere Massnahmen angewendet, wie beispielsweise die in Fig. 7a gezeigte Massnahme des Kühlens mit entionisiertem Wasser. Dennoch sind die erreichten Ergebnisse, insbesondere bei Berücksichtigung der Kosten-Nutzen-Relation nicht zufriedenstellend.

### Darstellung der Erfindung

Daher ist es Aufgabe der Erfindung ein gattungsgemässes Halbleitermodul derart weiterzubilden, dass die Isolationsfestigkeit auf einfache Weise beträchtlich erhöht wird gegenüber Durchschlägen und Pfaden für Teilentladungen vom Halbleiterement zur Grundschicht.

Erfindungsgemäss wird diese Aufgabe durch die Merkmale des Patentanspruchs 1 gelöst. In den Unteransprüchen sind vorteilhafte Weiterbildungen der Erfindung angegeben.

Durch die erfindungsgemässe Ausbildung einer Aussparung in der Grundschicht im Randbereich der darüber angeordneten ersten Metallisierung gemäss einem ersten Ausführungsbeispiel wird das Eindringen des Gels erheblich verbessert, so dass ein wesntlich grösserer gelgefüllter Spalt entsteht, in dem die Kante vollständig durch das Gel umschlossen ist, so dass Teilentlladeeinsetz- und Aussetzspannung um ungefähr 30% bis 50% erhöht werden. Weiterhin besteht bei dieser erfindungsgemässen Struktur der Vorteil, dass der Wärmewiderstand durch Beibehaltung des Abstandes zwischen Isolationsschicht und Grundschicht nicht erhöht wird. Zudem steigt durch die erfindungsgemässe Struktur die Fertigungsausbeute. Durch diese erfindungsgemässe Verbesserung der Isolationsfestigkeit können nicht nur kostengünstiger langlebige Halbleitermodule beispielsweise für Gleichspannungsbahnen ausgebildet werden, die Anwendung dieser Verbesserung ist bei allen laminierten Isolationen, auch auf dem Gebiet der Mikroelektronik mit höheren Betriebsspannungen sowie bei hochintegrierten flächigen Isolationen denkbar.

Alternativ ist es möglich, gemäss einem weiteren Ausführungsbeispiel der Erfindung eine Aussparung in der Isolationsschicht im Randbereich der darüber angerodneten zweiten Metallisierung auszubilden. Auf diese Weise wird zusätzlich zu einer besseren Umschliessung der Kanten mit Gel und den damit verbundenen Vorteilen des ersten Ausführungsbeispiel eine örtliche Trennung des Orts der Höchstfeldstärke und des Tripelpunkts erreicht. Dadurch wird eine Quergrenzfläche aus dem Stand der Technik in eine Längs- und eine Quergrenzfläche umgewandelt, d.h. nun existieren Feldlinien parallel und senkrecht zur Grenzfläche, so dass eine Ausbreitung von Entladungen behindert wird. Zudem wird auch die Höchstfeldstärke reduziert, da der Einfluss der unterschiedlichen Dielektrizitätszahlen durch die erfindungsgemässe Aussparung in der Isolationsschicht reduziert wurde.

Weitere Aufgaben, Merkmale und Vorteile der Erfindung werden aus der nachfolgenden Beschreibung bevorzugter Ausführungsbeispiele der Erfindung in Verbindung mit der Zeichnung offensichtlich.

### Kurze Beschreibung der Zeichnung

Nachfolgend wird die Erfindung anhand von bevorzugten Ausführungsbeispielen in Verbindung mit der Zeichnung näher erläutert.

Es zeigen:
Fig. 1 eine vereinfachte Schnittansicht eines ersten Ausführungsbeispiels eines erfindungsgemässen Halbleitermoduls mit einer wannenförmigen Aussparung in der Grundschicht direkt unter dem Rand einer ersten Metallisierung,
Fig. 2 eine vereinfachte Schnittansicht einer Modifikation des ersten Ausführungsbeispiels, wobei die Aussparung in der Grundschicht einen rechteckigen Querschnitt aufweist,
Fig. 3 eine vereinfachte Schnittansicht eines zweiten Ausführungsbeispiels eines erfindungsgemässen Halbleitermoduls mit einer Aussparung in der Isolationsschicht direkt unter dem Rand einer zweiten Metallisierung,
Fig. 4 einen Querschnitt durch ein viertes Ausführungsbeispiel des erfindungsgemässen Halbleitermoduls (ohne Darstellung der Aussparung(en)),
Fig. 5 einen Querschnitt durch eine beidseitig metallisierte Isolationsschicht gemäss einem fünften Ausführungsbeispiel des erfindungsgemässen Halbleitermoduls (ohne Darstellung der Aussparung(en)),
Fig. 6 einen Querschnitt durch eine beidseitig metallisierte Isolationsschicht gemäss einem sechsten Ausführungsbeispiel (ohne Darstellung der Aussparung(en)),
Fig. 7a einen Querschnitt durch ein schematisch dargestelltes herkömmliches Halbleitermodul einschliesslich Gehäuse und
Fig. 7b eine Draufsicht auf das herkömmliche Halbleitermodul gemäss Fig. 7a (ohne Gehäuse).

In der Zeichnung werden identische Teile mit den gleichen Bezugszeichen bezeichnet.

### Weg(e) zur Ausführung der Erfindung

Durch erfindungsgemässe konstruktive Massnahmen wird die Isolationsfestigkeit von Halbleitermodulen auch bei höheren Spannungen wesentlich verbessert.

Die Halbleitermodule sind dabei von den Schichten her wie herkömmliche Halbleitermodule, wie in Figur 7a gezeigt, aufgebaut und weisen in vertikaler Richtung übereinander eine Grundschicht 2, eine erste Metallisierung 4, eine Isolationsschicht 3, eine zweite Metallisierung 5 sowie ein Halbleiterelement 6 auf. Diese ganze Struktur ist in eine Gelmasse 7 eingebettet. Um die Gelmasse 7 herum ist ein Gehäuse 1 ausgebildet, das in den Figuren zur Vereinfachung weggelassen wurde.Die Grundschicht 2 dient als Kühler und besteht beispielsweise aus Kupfer, während die Isolationsschicht beispielsweise Keramikplatte 3 ist, die als Isolierung und Wärmeleiter dient und beispielsweise aus Aluminiumnitrid gebildet ist. Die das Halbleitermodul umschliessende Gelmasse 7 besteht beispielsweise aus Silikongel.

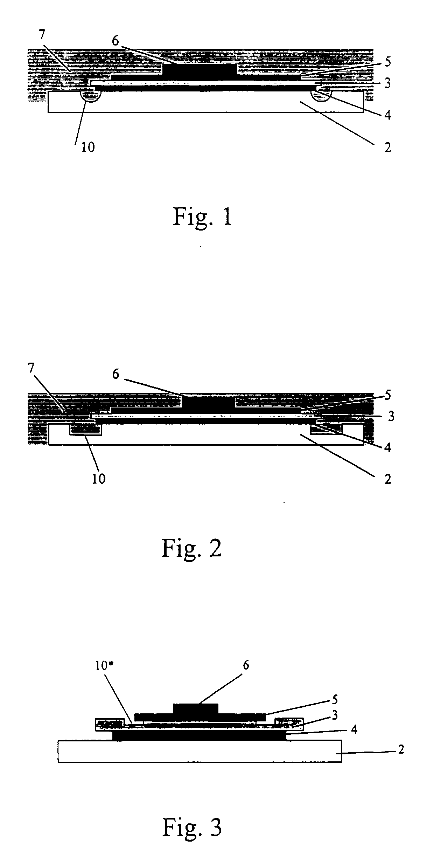

Im Unterschied zum Stand der Technik wird jedoch in einem ersten Ausführungsbeispiel der Erfindung gemäss Figur 1 in der Grundschicht 2 unterhalb der Aussenkante der ersten Metallisierung 4, die sich zwischen der Grundschicht 2 und der Isolationsschicht 3 befindet, eine Aussparung 10 in die Grundschicht 2 eingebracht. Diese Aussparung 10 erstreckt sich einerseits zu einem Teil seitwärts unter die erste Metallisierung 4 und andererseits auf die Seite von der ersten Metallisierung 4 weg zur Umgebung des Halbleitermoduls hin. Zur Umgebung hin kann die Aussparung 10 entweder eine beschränkte Ausdehnung aufweisen oder aber sich bis zum nächsten Halbleitermodul erstrecken. Somit kann die Aussparung also entweder die Form einer Rille besitzen, wie in Fig. 1 gezeigt, oder aber eine grössere, tieferliegende Fläche bis zum nächsten benachbarten Halbleitermodul hin bilden.

Bei herkömmlichen Halbleitermodulen traten bisher Teilentladungen sowohl an Kanten der das Halbleiterelement 6 tragenden zweiten Metallisierung 5 als auch an der die Isolationsschicht 3 tragenden ersten Metallisierung 4 auf. Im ersten Ausführungsbeispiel der Erfindung wird durch die Ausbildung der erfindungsgemässen Aussparung 10 in der Grundschicht 2 wird nun eine erste Metallisierungskante 4a der ersten Metallisierung 4 nur noch von der Gelmasse 7 umgeben, wodurch Teilentladungen im Vergleich zum Stand der Technikl insbesondere durch das bessere Eindringen des Gels beträchtlich reduziert werden.

Alternativ ist es ebenso in einem zweiten Ausführungsbeispiel der Erfindung möglich, eine Aussparung 10* in der Isolationsschicht 3 wiederum in beiden Richtungen unterhalb der zweiten Metallisierungskante 5a der zweiten Metallisierung 5 zwischen der Isolationsschicht 3 und der als Kühler dienenden Grundschicht 2 auszubilden, wie in Fig. 3 gezeigt. Zur Vereinfachung ist hier zusätzlich die Gelmasse 7 nicht gezeigt. Vorteilhafterweise kann hier die Unterkante der Metallisierungskante 5a noch abgerundet werden. Auch hier werden wie im ersten Ausführungsbeispiel durch die Umschliessung der zweiten Metallisierungskante 5a der zweiten Metallisierung 5 nur durch die Gelmasse 7 Teilentladungen beträchtlich reduziert, Es ergeben sich in diesem zweiten Ausführungsbeispiel jedoch noch zusätzliche vorteilhafte Effekte gegenüber dem ersten Ausführungsbeispeil.

Herkömmlich wird durch die zweite Metallisierung 5, die Gelmasse 7 und die Isolationsschicht 3 ein Tripelpunkt T ausgebildet, der mit dem Ort der Höchstfeldstärke zusammenfällt und an dem daher Feldüberhöhungen vorliegenden. Im erfindungsgemässen zweiten Ausführungsbeispiel werden nun durch die Ausbildung der Aussparung 10* in der Isolationsschicht 3 der Ort der Höchstfeldstärke und der Tripelpunkt T voneinander getrennt; es erfolgt eine Verschiebung des Tripelpunktes T an einem Ort T* von der zweiten Metallisierungskante 5a weg zur Mitte der zweiten Metallisierung 5 hin, an deren Unterseite zur Isolationsschicht 3 hin.

Somit wird eine herkömmliche reine Quergrenzfläche durch die erfindungsgemässe Aussparung 10* in eine Längs- und eine Quergrenzfläche an der Metallisierungskante 5a umgewandelt, an der Feldlinien parallel und senkrecht zur Grenzfläche existieren. Dies führt zu einer Behinderung der Ausbreitung von Entladungen.

Durch die Verschiebung des Tripelpunktes T an den Ort T* sowie einen durch Ausbildung der Aussparung 10* reduzierten Einfluss der unterschiedlichen Dielektrizitätszahlen der Schichten wird die Höchstfeldstärke an der zweiten Metallisierungskante 5a beträchtlich reduziert, so dass Teilentladungen gegenüber dem ersten Ausführungsbeispiel noch weiter reduziert werden können.

Die ersten beiden Ausführungsbeispiele beziehen sich auf Fälle, in denen ausschliesslich an Metallisierungskanten 4a bzw. 5a entweder der ersten oder der zweiten Metallisierungen 4 bzw. 5 beträchtliche Teilentladungen auftreten, während an der Metallisierungskante der anderen Metallisierung keine oder kaum Teilentladungen auftreten. Wenn jedoch an den Kanten der beiden Metallisierungen 4 bzw. 5 beträchtliche Teilentladungen auftreten, können gemäss einem dritten (nicht gezeigten) Ausführungsbeispiel die beiden ersten Ausführungsbeispiele wirkungsvoll kombiniert werden.

Im Fall dieses dritten Ausführungsbeispiels werden dann sowohl in der Isolationsschicht 3 (siehe Fig. 1 ) als auch in der Grundschicht 2 (siehe Fig. 3) Aussparungen 10 und 10* gebildet, durch die die Teilentladungen beträchtlich reduziert und zudem der Tripelpunkt T in der zweiten Metallisierungsschicht 5a an den Ort T* verschoben werden. Dadurch dass erfindungsgemäss die Metallisierungskanten 4a und 5a der Metallisierungen 4 und 5 nur noch von der Gelmasse 7 umgeben sind, kann man somit eine Reduzierung von Teilentladungen erreichen.

Die genaue Ausgestaltung der Aussparungen 10 und 10* hat keine Auswirkung auf die Effektivität ihrer Wirkung hinsichtlich der Reduktion von Teilentladungen. Durch verschieden gestaltete Aussparungen, beispielsweise in Form eines wannenförmigen (Fig. 2) oder eines rechteckförmigen (Fig. 1 ) Querschnittes, verändert sich lediglich der Herstellungsaufwand entsprechend der gewählten Form. Je nach Herstellungsverfahren des Halbleitermoduls können sich verschiedene Formen als am einfachsten realisierbar herausstellen. Es kann ebenso vorteilhaft sein, die Unterkanten der Metallisierungen 4 bzw. 5 im Randbereich, der direkt über den Aussparungen 10 bzw. 10* liegt, nach oben hin abzurunden.

Hinsichtlich der Tiefe t der Aussparung 10 bzw. 10* in vertikaler Richtung des Halbleitermoduls ist folgendes festzustellen. Obwohl sich die positiven Wirkungen der Aussparung 10 bzw. 10* mit zunehmender Tiefe t verstärken, ist festzustellen, dass bei den durchgeführten Versuchen eine Tiefe tₒₚₜ von 1 bis 1,5 mm Aussparungstiefe eine optimale Kombination von Aufwand und Nutzen erzielte. Zudem ist zu beachten, dass die maximale Tiefe durch den Schwellenwert begrenzt ist, der für die Stabilität der Schicht, in der die Aussparung 10 bzw. 10* ausgebildet wird, erforderlich ist.

Die minimale Aussparungstiefe tₘᵢₙ hängt von der jeweils verwendeten Metallisierungsschichtdicke ab; sie muss nämlich als Mindestmass (für die Aussparungstiefe t) die Schichtdicke der Metallisierung 4 bzw. 5 aufweisen, damit die erwünschte Wirkung, nämlich die Reduzierung von Teilentladungen überhaupt erzielt werden kann. Weiterhin hängt die erforderliche minimale Aussparungtiefe tₘᵢₙ auch von den Fliesseigenschaften der zum Eingiessen verwendeten Gelmasse 7 ab. Die minimale Aussparungstiefe tₘᵢₙ muss nämlich derart gewählt sein, dass die Gelmasse 7 oder ein anderer zum Eingiessen verwendeter Stoff in diese Aussparung 10 bzw. 10* hineinfliessen kann, da eine verbleibender Leeraum wiederum negative Auswirkungen auf die Teilentladungsfestigkeit hätte und die gewünschte Reduzierung von Teilentladungen nicht erzielt werden könnte.

Ein zusätzlicher positiver Effekt der Reduzierung der Teilentladungen durch Ausbildung der Aussparung 10* in der Schicht 3 besteht auch darin, dass die Feldüberhöhung an den Metallisierungskanten ebenfalls wirkungsvoll reduziert wird.

In einer weiteren vorteilhaften Weiterbildung der Erfindung wird, um Ablösungen der Gelmasse 7 von der Isolationsschicht 3 zu vermeiden, die ebenfalls zu Teilentladungen führen können, ein (nicht gezeigter) Primer bzw. eine Grundierung verwendet. Dieser Primer wird auf die vollständige Oberfläche des Halbleitermoduls aufgebracht, bevor dessen Einbettung in die Gelmasse 7 erfolgt. Mit Hilfe des Primers kommt es zu einer chemischen Bindung zwischen den Schichten, unter anderem auch zwischen der freiliegenden Oberfläche der Isolationsschicht 3 und der Gelmasse 7, so dass eine Ablösung zuverlässig verhindert wird, wodurch wiederum Teilentladungen verringert werden.

Schliesslich besitzt die erfindungsgemässe Verwendung der Aussparung 10 bzw. 10* rund um das Halbleitermodul noch einen weiteren Vorteil. Durch die entstehenden "Inseln" aus Halbleitermodulen wird bei der erfindungsgemässen Ausgestaltung die bei herkömmlichen Halbleitermodulen unbedingt erforderliche Verwendung eines Lötstops überflüssig, da das Lot durch die Aussparung nicht mehr in den Rest der Umgebung fliesst.

Als weitere Massnahme, mit der die erfindungsgemässe Anordnung in ihrer Wirkung noch verbessert werden kann, ist eine Ausgestaltung vorgesehen, durch die in den Randbereichen der ersten und zweiten Metallisierung 4 bzw. 5 ein möglichst homogenes Feld erhalten werden kann, wodurch Feldüberhöhungen minimiert werden. Im folgenden werden nun vierte bis sechste Ausführungsbeispiele beschrieben, in denen diese zusätzliche Ausgestaltung der ersten und zweiten Metallisierung 4 und 5 in den Randbereichen durchgeführt wurde. In der Darstellung der Modifikationen gemäss dem vierten bis sechsten Ausführungsbeispiel in den Fig.en 4 bis 6 ist die Aussparung 10 und/oder 10* nicht gezeigt. Sie ist entsprechend der Darstellung gemäss den Fig.en 1 bis 3 auszugestalten.

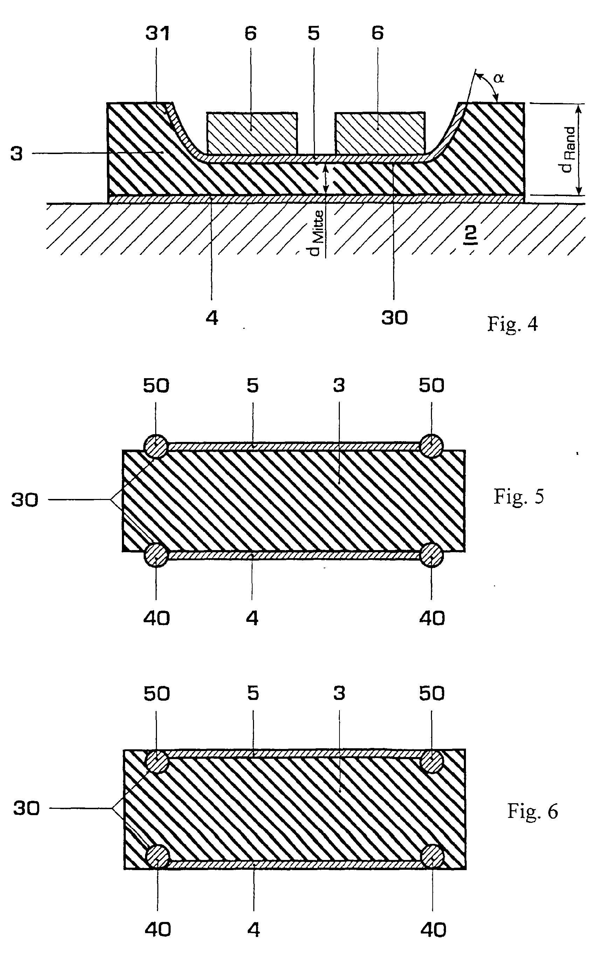

Um dieses möglichst homogene Feld zu erzielen, wird in einer Ausführungsform gemäss einem vierten Ausführungsbeispiel, das in Fig. 4 veranschaulicht ist, mindestens eine der Metallisierungen 4 bzw. 5 wannenförmig gewölbt, wobei der Abstand zu einer auf der gegenüberliegenden Seite der Isolationsschicht 3, d.h. beispielsweise der Aluminiumnitridschicht, angeordneten zweiten Metallisierung 5 bzw. 4 zu den Rändern hin zunimmt, wobei die jeweilige Aussparung unter oder senkrecht unter den Metallisierungskanten nicht gezeigt ist.. Auf diese Weise wird eine Feldüberhöhung im Randbereich durch den erhöhten Abstand reduziert.

Als zusätzliche Massnahme ist es weiterhin auch möglich, die Kanten der ersten und/oder zweiten Metallisierungen auf der Ober- und Unterseite der Metallisierung zu runden. Dies hat ebenfalls eine erheblich Reduktion der Feldstärke zur Folge.

Im Unterschied zu dem ersten bis dritten Ausführungsbeispiel wird im vierten Ausführungsbeispiel die Isolationsschicht 3 vorzugsweise auf der den Halbleiterelementen 6 zugewandten Seite mit einer Vertiefung 30 versehen. Diese Vertiefung 30 ist wannenförmig ausgebildet, wobei mindestens zwei, vorzugsweise alle Seiten hochgezogen sind. Dabei ist die Vertiefung 30 in der Mittelzone flach und weist steile seitliche Flanken 31 auf. Typischerweise beträgt die Tiefe der Wanne mindestens die Hälfte der Dicke der Isolationsschicht 3 und die Flanken 31 schliessen mit der Oberfläche der Isolationsschicht 3 einen Winkel α von mindestens 30° ein. In der Vertiefung 30 ist die zweite Metallisierung 5 vorhanden, die sich über die seitlichen Flanken 31 erstreckt. Die Innenfläche der wannenförmigen Vertiefung 30 bildet eine Äquipotentialfläche, wobei es hierfür nicht zwingend notwendig ist, dass die gesamte Innenfläche mit einer durch Löten oder direktes Kupferbonden (DCB = "direct copper bonding") aufgebrachten Metallisierungsschicht beschichtet ist. Es reicht im allgemeinen aus, wenn lediglich der plane Teil der wannenförmigen Vertiefung metallbeschichtet ist, wobei die Schichtdicke vorzugsweise 0,1 bis 0,3 mm beträgt. Die Flanken 31 können mit einer aufgedampften Metallisierungsschicht oder einer anderen, auch eine geringere elektrische Leitfähigkeit aufweisenden Schicht versehen sein.

Die gegenüberliegende, der Grundschicht 2 zugewandte Seite der Isolationsschicht 3 ist vorzugsweise planar ausgebildet und mit einer planen ersten Metallisierung 4 versehen. Wie in Fig. 4 ersichtlich, nimmt der Abstand zwischen den zwei Metallisierungen 4 und 5 zu deren Rändern hin zu, wobei der Abstand d_{Rand} der Ränder ein Vielfaches des Abstandes d_{Mitte} der Mittelzonen beträgt. Typische Werte sind für d_{Rand} 3 bis 5 mm und für d_{Mitte} 1 bis 2 mm. Durch den erhöhten Abstand wird die in den Randgebieten entstehende Feldüberhöhung reduziert.

Hiermit ergibt sich in Verbindung mit der Aussparung 10 in der Grundschicht 2 und/oder der Aussparung 10* in der Isolationsschicht 3 jeweils im Bereich der Ränder der Metallisierungen 4 bzw. 5 eine noch wesentlich verbesserte Isolations- und Teilentladungsfestigkeit, wobei die in Fig. 4 nicht gezeigten Aussparungen entsprechend den Fig.en 1 bis 3 auszubilden sind.

In einer weiteren alternativen Ausführungsform gemäss einem fünften Ausführungsbeispiel, das in Fig. 5 gezeigt ist, wird die Wölbung der Metallisierung durch wulstförmige Abschlüsse 40 und 50, vorzugweise mit rundem Querschnitt, an den Ecken und/oder Kanten gebildet. In einer bevorzugten Variante weist die Isolationsschicht 3 Vertiefungen 30 zur Aufnahme der vorstehenden Wülste 40 bzw. 50 auf.

In diesem Fall ist die Isolationsschicht 3 im wesentlichen planparallel ausgebildet und mit zwei im wesentlichen planen, einander gegenüberliegenden Metallisierungen 4 und 5 versehen, die an ihren Ecken und/oder Rändern Wölbungen in Form von wulstförmigen Abschlüssen 40 bzw. 50 aufweisen. Diese wulstförmigen Abschlüsse 40 bzw. 50 weisen vorzugsweise eine runden Querschnitt auf und haben einen Durchmesser, der ein Vielfaches der Dicke der Metallisierungen beträgt. Typische Werte liegen bei 0,2 bis 0,3 mm für die Metallisierungsdicke und 1 bis 4 mm für den Durchmesser der Wulst. Die wulstförmigen Abschlüsse 40 bzw. 50 entschärfen die Ecken bzw. Kanten und reduzieren somit ebenfalls die Feldüberhöhung. In diesem Ausführungsbeispiel liegen die Metallisierungen 4 bzw. 5 auf der planen Oberfläche der Isolationsschicht 3 auf, wobei lediglich die wulstförmigen Abschlüsse 40 bzw. 50 in Vertiefungen 30 aufgenommen sind.

In diesem fünften Ausführungsbeispiel werden die Aussparungen 10 bzw. 10* in der Grundschicht 2 und/oder der Isolationsschicht 3 jeweils an den Rändern der Metallisierungen 4 bzw. 5 ausgebildet. Beispielhaft sind in Fig. 5 beide Aussparungen 10 und 10* dargestellt, jedoch ist es ebenso wie im ersten und zweiten Ausführungsbeispiel auch möglich, nur eine Aussparung 10 bzw. 10* auszubilden, wenn die wesentlichen Teilentladung von dort ausgeht.

Ebenso kann die gesamte Metallisierung 4 bzw. 5 jedoch auch, wie in Fig. 6 gezeigt, gemäss einem sechsten Ausführungsbeispiel in die Isolationsschicht 3 eingelassen sein, so dass sie mit dieser eine plane Oberfläche bildet. Dadurch lässt sich beim Auffüllen mit der Gelmasse 7, beispielsweise Silikongel die Bildung von Bläschen vermeiden, da schwer zugängliche kleine Hohlräume vermieden werden.

Hierfür sind die Metallisierungen 4 bzw. 5 vollständig in eine entsprechend geformte Vertiefung 30 der Keramikplatte 3 eingelassen, wobei sie mit dieser eine gemeinsame plane Oberfläche bilden.

Somit ist es durch die erfindungsgemässe Ausbildung einer oder zweier Aussparungen in der Grundschicht und/oder in der Isolationsschicht auf einfache und kostengünstige Weise möglich, Teilentladungen wesentlich zu reduzieren.

Zusammenfassend offenbart die vorliegende Erfindung ein Halbleitermodul mit verbesserter Teilentladungsfestigkeit. Das Halbleitermodul umfasst eine Grundschicht 2, eine erste Metallisierung 3, eine zweite Metallisierung 5 sowie mindestens ein Halbleiterelement 6, die übereinander angeordnet sind. Erfindungsgemäss ist in der Grundschicht 2 und/oder der Isolationsschicht 3 in einem Bereich unter einer Kante der sich in einer Ebene darüber befindlichen ersten bzw. zweiten Metallisierung 4, 5 eine Aussparung 10 derart ausgebildet ist, dass die Kante keine Verbindung mit der sich in der Ebene darunter befindlichen Grundschicht 2 und/oder Isolationsschicht 3 hat. Das gesamte Halbleitermodul ist in eine Gelmasse 7 eingegossen. Auf diese Weise wird ein durch die jeweilige Metallisierungskante nur von der Gelmasse 7 umgeben, so dass Teilentladungen beträchtlich reduziert werden.

## Patentansprüche

1. Halbleitermodul mit einer Grundschicht (2), einer ersten Metallisierung (4), einer Isolationsschicht (3), einer zweiten Metallisierung (5) sowie mindestens einem Halbleiterelement (6), die übereinander angeordnet sind,
dadurch gekennzeichnet, dass
in der Grundschicht (2) und/oder der Isolationsschicht (3) in einem Bereich unterhalb einer Kante der sich in einer Ebene darüber befindlichen ersten bzw. zweiten Metallisierung (4, 5) eine Aussparung (10; 10*) derart ausgebildet ist, dass die Kante keine Verbindung mit der sich in der Ebene darunter befindlichen Grundschicht (2) und/oder Isolationsschicht (3) hat.

2. Halbleitermodul nach Anspruch 1, dadurch gekennzeichnet, dass
die Aussparung (10; 10*) in Form einer Rille ausgebildet ist.

3. Halbleitermodul nach Anspruch 2, dadurch gekennzeichnet, dass
die Rille einen wannenförmigen Querschnitt aufweist.

4. Halbleitermodul nach Anspruch 2, dadurch gekennzeichnet, dass
die Rille einen rechteckigen Querschnitt aufweist.

5. Halbleitermodul nach Anspruch 1, dadurch gekennzeichnet, dass
die Aussparung (10; 10*) sich bis zum benachbarten Halbleitermodul erstreckt, so dass die Grundschicht (2) und/oder die Isolationsschicht (3) einen Podest bildet.

6. Halbleitermodul nach einem der Ansprüche 1 bis 5, dadurch gekennzeichnet, dass
keine Lötstoppschicht ausgebildet ist.

7. Halbleiterelement nach einem der Ansprüche 1 bis 6, dadurch gekennzeichnet, dass
auf das Halbleitermodul über die gesamt Oberfläche eine Primerschicht aufgebracht ist, die als Haftvermittler zu einer das Halbleitermodul um- schliessenden Masse (7) dient.

8. Halbleitermodul nach Anspruch 7, dadurch gekennzeichnet, dass
die umschliessende Masse eine Gelmasse ist.

9. Halbleitermodul nach Anspruch 8, dadurch gekennzeichnet, dass
die Gelmasse ein Silikongel ist.

10. Halbleitermodul nach einem der vorangehenden Ansprüche 1 bis 9, dadurch gekennzeichnet, dass
mindestens eine der ersten oder zweiten Metallisierungen (4, 5) gewölbt ausgebildet ist.

11. Halbleitermodul nach Anspruch 10, dadurch gekennzeichnet, dass
die Isolationsschicht (3) mindestens eine Vertiefung (30) zur Aufnahme einer Wölbung der ersten oder zweiten Metallisierung (4, 5) aufweist.

12. Halbleitermodul nach Anspruch 10, dadurch gekennzeichnet, dass
die gewölbte erste Metallisierung (4) wannenförmig ausgebildet ist und der Abstand zwischen der ersten und zweiten Metallisierung (4, 5) zu deren Rändern hin zunimmt.

13. Halbleitermodul nach Anspruch 12, dadurch gekennzeichnet, dass
die Isolationsschicht (3) mindestens auf einer Oberfläche eine wannenförmige Vertiefung (30) mit seitlichen Flanken (31) aufweist, in der die gewölbte erste Metallisierung (4) angeordnet ist, wobei sie sich über die seitlichen Flanken (31) erstreckt.

14. Halbleitermodul nach Anspruch 13, dadurch gekennzeichnet, dass
eine erste Oberfläche der Isolationsschicht (3) eine Vertiefung (30) aufweist und eine zweite gegenüberliegende Oberfläche planar ausgebildet ist, wobei beide Oberflächen mit der ersten bzw. zweiten Metallisierung (4, 5) versehen sind.

15. Halbleitermodul nach Anspruch 13 oder 14, dadurch gekennzeichnet, dass
der Abstand d_{Rand} der Ränder der ersten und zweiten Metallisierungen (4, 5) ein Vielfaches des Abstandes d_{Mitte} der Mittelzonen der ersten und zweiten Metallisierungen (4, 5) beträgt.

16. Halbleitermodul nach Anspruch einem der Ansprüche 1 bis 15, dadurch gekennzeichnet, dass
die Ecken und/oder Kanten der ersten und zweiten Metallisierung (4, 5) wulstförmig ausgebildet sind.

17. Halbleitermodul nach einem der Anspruch 16, dadurch gekennzeichnet, dass
die Isolationsschicht (3) eine planare Oberfläche aufweist, die von Vertiefungen (30) zur Aufnahme der wulstförmigen Enden und/oder Kanten unterbrochen ist, und
die erste und zweite Metallisierung (4, 5) mit Ausnahme der wulstförmigen Ecken oder Kanten auf der planaren Oberfläche aufliegt.

18. Halbleitermodul nach Anspruch 16, dadurch gekennzeichnet
die ersten und zweiten Metallisierungen (15) vollständig in die Isolationsschicht (3) eingelassen sind, wobei sie mit der Isolationsschicht (3) eine gemeinsame plane Oberfläche bilden.

19. Halbleitermodul nach Anspruch 16, 17 oder 18, dadurch gekennzeichnet, dass
die Ecken und/oder Kanten einen zumindest annähernd runden Querschnitt aufweisen.

20. Halbleitermodul nach einem der Ansprüche 1 bis 9, dadurch gekennzeichnet, dass
die Kanten der ersten und/oder zweiten Metallisierung (4, 5) gerundet sind.
